# EUROPÄISCHE PATENTSCHRIFT

(11) **EP 0 462 409 B1**
(45) Veröffentlichungstag und Bekanntmachung des Hinweises auf die Patenterteilung: **13.07.1994**
(21) Anmeldenummer: 91108291.5
(22) Anmeldetag: 23.05.1991
(51) Int. Cl.: C04B 35/00, H01B 12/02, H01L 39/24, B28B 21/30, B22D 13/02

(54) **Verfahren zur Herstellung rohrförmiger Formteile aus Hochtemperatur-Supraleiter-Material sowie eine Anlage zu seiner Durchführung**
Process for the production of tube shaped mouldings out of high temperature superconductor material and plant for carrying out this process
Procédé de production de pièces moulées tubulaires d'un matériau supraconducteur à haute température et usine pour son exécution

(30) Priorität: 18.06.1990 DE 4019368
(43) Veröffentlichungstag der Anmeldung: 27.12.1991
(73) Patentinhaber: HOECHST AKTIENGESELLSCHAFT, 65926 Frankfurt am Main (DE)
(72) Erfinder: Preisler, Eberhard, Dr., W-5042 Erftstadt (DE); Bock, Joachim, Dr., W-5042 Erftstadt (DE); Holzem, Johannes, W-5030 Hürth (DE); Dorn, Friedrich-Wilhelm, Dr., W-5030 Hürth (DE)

(56) Entgegenhaltungen:
- EP-A- 0 344 813
- DE-A- 3 830 092
- DE-C- 3 509 235

## Beschreibung

Die vorliegende Erfindung betrifft ein Verfahren zur Herstellung rohrförmiger Formteile aus Hochtemperatur-Supraleiter- Material auf der Basis von Oxiden des Bismuts, Calciums, Strontiums und Kupfers sowie eine Anlage zu seiner Durchführung.

Es ist bekannt, Gegenstände aus supraleitendem Material durch Vergießen aus einer Schmelze von supraleitendem Material, insbesondere aus einer Schmelze der Verbindung Bi₂Sr₂CaCu₂Oₓ herzustellen (vergl. DE-OS 38 30 092). Die vorliegende Erfindung bezieht sich jedoch auf alle bismuthaltigen Zusammensetzungen, die erschmolzen und nach dem Vergießen durch eine geeignete Wärmebehandlung wiederum in den supraleitenden Zustand überführt werden können, beispielsweise auch auf die als Dreischichtverbindung bekannte bleihaltige Verbindung (Bi,Pb)₂Sr₂Ca₂Cu₃O₁₀.

Für praktische Anwendungen müssen diese Verbindungen, die als Oxide keramischen Charakter haben, in Formen überführt werden, die dem beabsichtigten Verwendungszweck entsprechen. Einige bestimmte elektrotechnische Anwendungen sehen zylindrische Hohlformen unterschiedlicher Abmessungen vor, u.a. dickwandige Rohre mit vergleichsweise kleinem Durchmesser und größerer Länge, die in der Hochfrequenztechnik Anwendung finden können. Solche Gegenstände können durch Vergießen zu Stangen, die jedoch nachträglich aufgebohrt werden müßten, hergestellt werden. Bei größeren Abmessungen stößt aber diese Technik auf erhebliche Schwierigkeiten, weil massive Gußstücke beim Abkühlen leicht innere Spannungen ausbilden, die zu Rissen führen, wodurch solche Werkstücke unbrauchbar werden. Auch vermindert der Materialverlust beim Aufbohren zu Röhren mit großen Durchmessern und geringen Wandstärken die Wirtschaftlichkeit.

Die gestellte Aufgabe verlangt rohrförmige Stücke aus supraleitendem Material mit Durchmessern über 20 mm bis zu 500 mm und Wandstärken, die in relativ weiten Grenzen (wenige mm bis cm) variieren können, und von unterschiedlichen Längen.

Nun ist aus der Gießereitechnik das sog. Schleudergußverfahren zur Herstellung von Rohren aus Gußeisen bekannt. Dabei wird eine keramische Rohrkokille drehbar gelagert und über eine der zu produzierenden Rohrlänge entsprechende Gießrinne gefahren. Dann wird die Kokille in Rotation versetzt und mit dem Abgießen der Gußeisenschmelze je nach gewünschter Rohrdicke mehr oder weniger schnell zurückgezogen. So entsteht durch "Aufwickeln" des erstarrenden Gußeisens das Rohr. Nach seinem Abkühlen wird das Rohr aus der Kokille herausgezogen.

Supraleiter sind keramische Materialien, aus denen in der Regel durch keramische Methoden wie Verpressen der Pulver und Sintern derselben Formkörper in bescheidenen Dimensionen wegen der erforderlichen Preßdrücke hergestellt werden. Es konnte aber schon gezeigt werden, daß die Schmelzsynthese, die eine Gießtechnik ermöglicht, zu wesentlich besseren supraleitenden Eigenschaften der sog. Zweischichtverbindung Bi₂Sr₂CaCu₂Oₓ führt, nämlich zu vereinfachter Herstellung, verbesserter Phasenreinheit und guten kritischen Werten (Tc, jc; vergl. J. Bock und E. Preisler, Solid State Communications, Vol. 72, No. 5, pp. 453-458 (1989) und M. Peuckert et al., Physica C 162-164, (1989) 893-894). Es erweist sich nun als besonders vorteilhaft, diese Gießtechnik in Form der Schleudergußtechnik anzuwenden, wenn es sich um zylindrische Hohlkörper handelt.

Im einzelnen betrifft die vorliegende Erfindung ein Verfahren zur Herstellung rohrförmiger Formteile aus Hochtemperatur-Supraleiter-Material auf der Basis von Oxiden des Bismuts, Calciums, Strontiums und Kupfers, welches dadurch gekennzeichnet ist, daß man eine homogene Schmelze des Oxidgemisches in vorgegebener Stöchiometrie herstellt, daß man die Schmelze mit Temperaturen von 900 bis 1100°C in eine um ihre waagerechte Achse rotierende Gießzone einlaufen läßt, daß man das erstarrte Formteil aus der Gießzone entnimmt und daß man das Formteil 4 bis 150 Stunden bei 700 bis 900°C in sauerstoffenthaltender Atmosphäre tempert.

Das erfindungsgemäße Verfahren kann weiterhin wahlweise auch dadurch ausgestaltet sein, daß
a) die Stöchiometrie gemäß der Formel Bi₂Sr₂CaCu₂Oₓ, wobei x für Werte zwischen 8 und 8,5 steht, vorgegeben ist;
b) die Stöchiometrie gemäß der Formel (Bi,Pb)₂Sr₂Ca₂Cu₃Oₓ, wobei x für Werte zwischen 10 und 13 steht, vorgegeben ist;
c) man die Gießzone mit 300 bis 1200 Upm, vorzugsweise mit 400 bis 600 Upm, rotieren läßt.

Weiterhin betrifft die Erfindung eine Anlage zur Durchführung dieses Verfahrens, die durch eine drehbar angeordnete Gußkokille, welche an ihren offenen Stirnseiten mit je einem den freien Querschnitt verringernden Abschlußring versehen ist, eine in das Innere der Gußkokille hineinragende Gießrinne und einen oberhalb der Gießrinne angeordneten Vorratsbehälter, durch welchen die Gießrinne mit Schmelze beaufschlagbar ist, gekennzeichnet ist.

Die genannte Anlage kann auch noch dadurch weitergebildet sein, daß
d) die Gußkokille regelbar antreibbar ist;
e) die Gußkokille mit einer parallel zum Hüttenflur angeordneten, gegebenenfalls in einem Achsenlager geführten Welle kraftschlüssig verbunden ist, wobei die Welle ihrerseites mit einem regelbaren Motor verbunden ist;
f) die Gußkokille auf einem regelbaren Antrieb drehbar gelagert ist und mit einer Gegendruckrolle in ihrer Position gehalten wird;
g) die Gußkokille an ihrer einen Stirnseite geschlossen ist und an ihrer offenen Stirnseite mit einem ihren freien Querschnitt verringernden Abschlußring versehen ist;
h) die Gußkokille aus mehreren, in ihrer Längsachse verlaufenden Segmenten aufgebaut ist, welche durch mehrere, ihren Umfang umgreifende Spannringe zusammengehalten werden;
i) die Gußkokille an der Innenwand ihres einen Endes eine Stufe aufweist, während der Abschlußring an ihrem entgegengesetzten Ende eine nach innen weisende größere Ausnehmung aufweist;
j) die Stufe durch Einlegen eines Ringes gebildet wird;
k) die Gußkokille mindestens im Bereich ihrer Innenwandung aus metallischen Material besteht;
l) das Material nichtrostender Stahl nach DIN 17 440, insbesondere Werkstoff-Nr. 1.4571, ist;
m) das Material Buntmetall, insbesondere Nickel und/oder Kupfer, ist.

Da das zu formende Material keramisch ist, ist es beim Verfahren gemäß der Erfindung notwendig, statt einer keramischen eine metallische Kokille zu wählen, um eine Reaktion der Schmelze mit der Keramikwand der Kokille auszuschließen. Eine solche Reaktion würde nämlich die Entfernung des Gußkörpers wesentlich erschweren, wenn nicht gar unmöglich machen. Überraschenderweise war es jedoch möglich, den erstarrten Gußkörper aus der Kokille herauszuziehen, ohne daß die Kokillenwände gegenüber der Drehachse der Kokille geneigt waren. Durch die Schrumpfung der heißen Schmelze beim Erstarren und die weitere Abkühlung vermindert sich der Durchmesser des Gußkörpers um einen geringen Betrag, der aber zu seiner vollständigen Ablösung von der Kokillenwand ausreicht. Es ist jedoch auch möglich, der Kokille eine schwach konische Form zu geben, um die Herauslösung weiter zu erleichtern, wenn die Bedürfnisse des Anwendungszwecks eine solche konische Form gestatten.

Beim erfindungsgemäßen Verfahren besteht ein besonderer Vorteil der metallischen Kokille in ihrer guten Wärmeleitfähigkeit. Es hat sich erwiesen, daß normalerweise die Kokille nicht vorgeheizt werden muß. Beim Einfließen der Schmelze erstarrt diese sehr rasch in sehr dünner Schicht infolge der Abkühlung durch die Kokille, wobei diese dünne Schicht glasartigen Charakter hat, während die große Masse des erstarrten Materials ein heterogenes Gefüge besitzt. Durch die rasche Abkühlung wird eine Reaktion der Schmelze mit dem Kokillenmaterial praktisch vollständig verhindert.

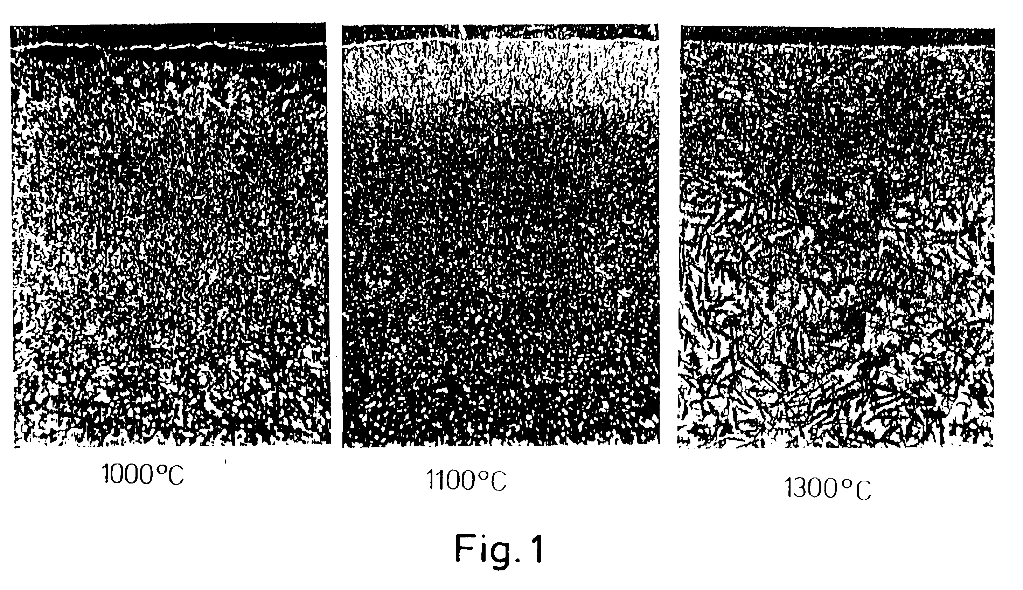

Die Herauslösung des Gußkörpers aus der Kokille ist beim Verfahren gemäß der Erfindung um so leichter möglich, je kürzer die Kokille im Vergleich zu ihrem Durchmesser und je stabiler der Gußkörper ist. Die Stabilität des Gußkörpers hängt sowohl von seinen Dimensionen als auch von eventuellen inneren Spannungen ab, die beim Abkühlen auftreten können. Diese inneren Spannungen haben etwas mit der Art der Kristallbildungen zu tun. Diese Kristallbildungen und damit auch das Auftreten der inneren Spannungen hängen offensichtlich mit der Temperatur dar Schmelze und mit der Aufschmelzdauer zusammen. Da die Temperatur ebenso wie die Aufschmelzdauer einen Einfluß auf den Sauerstoffgehalt der Schmelze haben, ist zu vermuten, daß auch der Sauerstoffgehalt das Gefüge beeinflußt. Aus Fig. 1 ist ersichtlich, wie sich das Erscheinungsbild der erstarrten Schmelze mit der Schmelzetemperatur ändert. Daraus geht hervor, daß vor dem Gießen der Verbindung Bi₂Sr₂CaCu₂Oₓ die Schmelzetemperatur 1050°C nicht übersteigen soll.

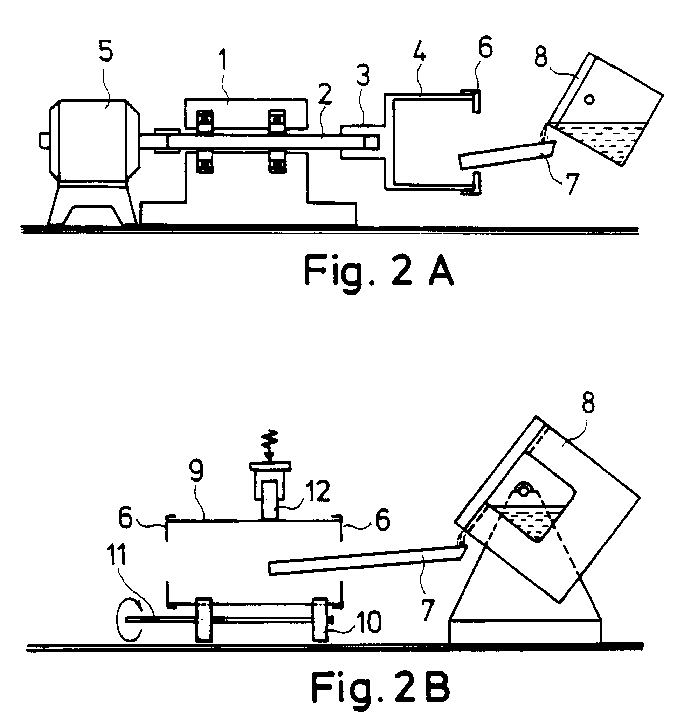

Bei der Anlage zur Durchführung des erfindungsgemäßen Verfahrens kann bei relativ langgestreckten Formkörpern und dementsprechend langer Kokille die einseitige Lagerung der Kokille zu Schwierigkeiten führen. In diesem Fall ist es angebracht, das der Halterung entgegengesetzte Ende der Kokille durch ein Rollenlager zu unterstützen oder die in Fig. 2 B gezeigte Anordnung für eine frei abrollende Kokille zu benutzen.

In der beigefügten Zeichnung ist neben Schliffbildern von erfindungsgemäß hergestellten Formkörpern sowie einer Widerstand-Temperatur-Kurve eine Anlage zur Durchführung des erfindungsgemäßen Verfahrens schematisch und im Schnitt dargestellt. Dabei zeigen:
- Fig. 1: Mikroskopische Schliffbilder von Schnitten durch Formkörper der Zusammensetzung Bi₂Sr₂CaCu₂Oₓ, welche vor ihrer Erstarrung auf 1000 bzw. 1100 bzw. 1300°C erhitzt worden waren;
- Fig. 2A: eine Schleudergußapparatur, bei welcher die Kokille auf eine rotierende Achse aufgeschoben ist;
- Fig. 2B: eine Schleudergußapparatur, bei welcher die Kokille auf rotierenden Rollen aufliegt;
- Fig. 3: eine aus Segmenten aufgebaute Kokille (im Längs- und Querschnitt);
- Fig. 4A: eine spezielle Ausführung der Kokille gemäß Fig. 2A;
- Fig. 4B: aufeinandersetzbare Formteile, welche bei Verwendung der Kokille gemäß Fig. 4A erhalten werden;
- Fig. 5: Widerstands-Temperatur-Kurve des Materials, aus welchem der gemäß Beispiel 1 erhaltene zylinderförmige Gußkörper bestand.

Nach Fig. 2A ist eine in einem Achsenlager 1 befindliche Welle 2 mit ihrem einen Ende in den zentrisch angeordneten Fortsatz 3 einer Kokille 4 eingeschoben, während das entgegengesetzte Ende der Welle 2 mit einem regelbaren Elektromotor 5 kraftschlüssig verbunden ist. Auf das offene Ende der Kokille 4 ist ein Abschlußring 6 aufgeschoben. In das offene Ende der Kokille 4 ragt eine Gießrinne 7 hinein, welche aus einem Tiegel 8 mit Schmelze beaufschlagbar ist.

Nach Fig. 2B ist eine langgestreckte, beidseitig offene Kokille 9 auf mit Rollen 10 versehenen Achsen 11 aufgelegt, wobei eine der Achsen 11 mit einem nicht dargestellten regelbaren Antrieb kraftschlüssig verbunden ist. Auf der Oberseite der Kokille 9 liegt eine Gegendruckrolle 12 auf.Auf die beiden offenen Enden der Kokille 9 ist jeweils ein Abschlußring 6 aufgeschoben. In die Kokille 9 ragt eine Gießrinne 7 hinein, welche aus einem Tiegel 8 mit Schmelze beaufschlagbar ist.

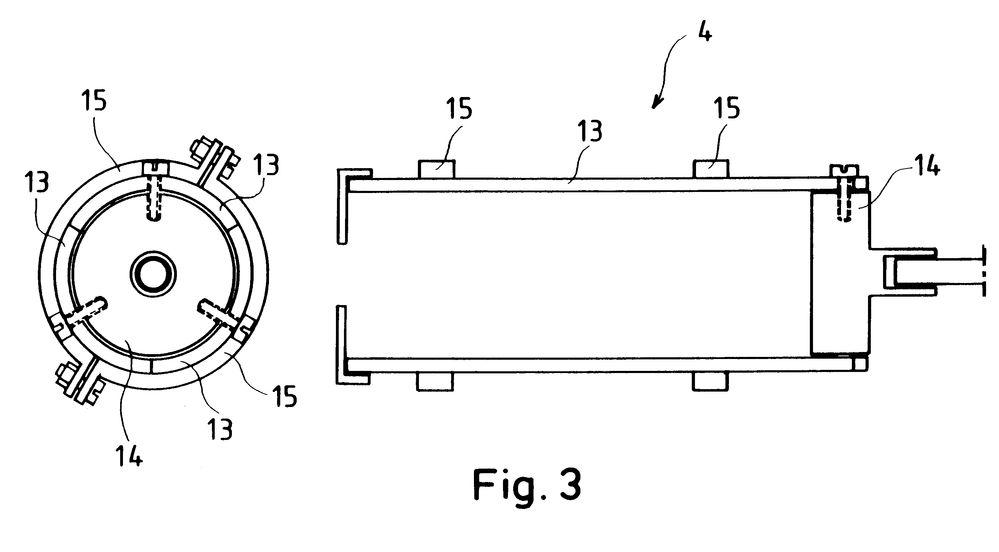

Nach Fig. 3 ist die in der Apparatur gemäß Figur 2A einsetzbare Kokille 4 zur erleichterten Entnahme des zylinderförmigen Formteiles aus drei Segmenten 13 aufgebaut, wobei die Segmente 13 mit der Kokillenbasis 14 verschraubt sind und durch Spannringe 15 zusammengehalten werden.

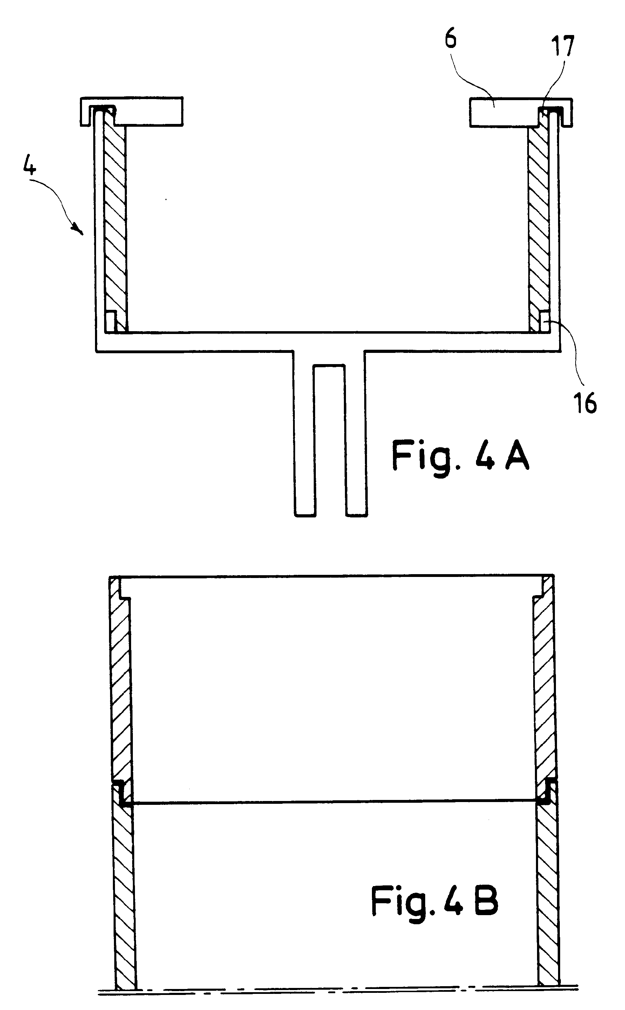

Nach Fig. 4A ist in die in der Apparatur gemäß Fig. 2A einsetzbare Kokille 4 an ihrer der Öffnung entgegengesetzten Seite ein Ring 16 eingelegt. Weiterhin ist in den Abschlußring 6 der Kokille 4 eine Ringnut 17 eingearbeitet, deren Breite größer als die Wandstärke der Kokille 4 ist. Die mit Hilfe der so ausgestatteten Kokille 4 herstellbaren zylinderförmigen Formkörper sind an ihrem oberen und unteren Ende so ausgebildet, daß sie nach dem Prinzip von Nut und Feder aufeinander stapelbar sind (vergl. Fig. 4B).

### Beispiel 1

Auf die Achse eines stabilen Lagers wurde auf einer Seite ein regelbarer Elektromotor und auf der anderen Seite eine Kokille aus Edelstahl gemäß Werkstoff-Nr. 1.4571 nach DIN 17 440 angesetzt (vergl. Fig. 2A). Die Kokille bestand aus einem zentrischen Topf mit einer Wandstärke von 1 mm, der zum Abschluß einen Ring trug, der dazu diente, eine eingebrachte Schmelze daran zu hindern, aus dem Topf auszulaufen. Die Anordnung wurde so aufgebaut, daß die Rotationsachse des Topfes waagerecht steht. Der Topf hatte 10 cm Durchmesser und 11 cm Höhe. Der Abschlußring hatte eine Breite von 10 mm, gerechnet nach innen vom Mantel des Topfes aus. Eine Gießrinne aus Kupferblech ragte in das Innere des Topfes hinein (vergl. Fig. 2A).

In einem Aluminiumoxidtiegel wurden 800 g der Zweischichtverbindung Bi₂Sr₂CaCu₂Oₓ aufgeschmolzen und 20 Minuten bei einer Temperatur von 1030°C gehalten. Dann wurde der Topf auf eine Drehgeschwindigkeit von 500 Umdrehungen pro Minute (Upm) gebracht und die Schmelze auf die Gießrinne entleert. Die Schmelze verteilte sich infolge der Fliehkraft gleichmäßig an der Topfwand und erstarrte in kurzer Zeit.

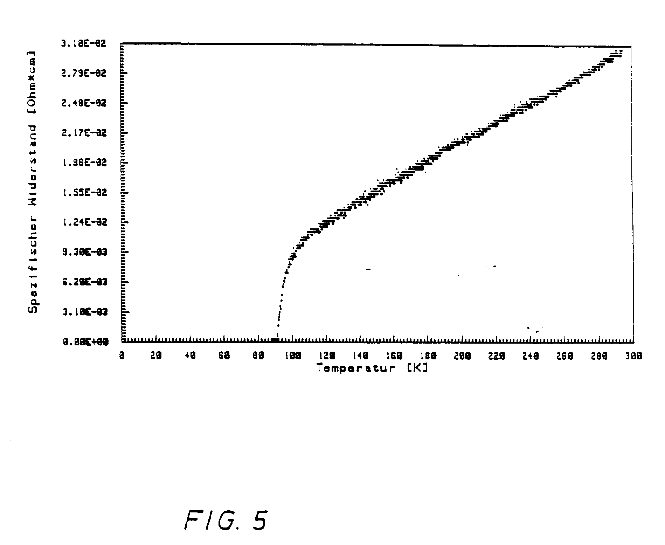

Nach dem Abkühlen und Abnehmen des Ringes konnte der zylinderförmige Gußkörper aus dem Topf problemlos entnomen werden. Er war in diesem Zustand nicht supraleitend. Nach einer Wärmebehandlung (24 h bei 750°C und 120 h bei 850°C bei einer Aufheizrate von 40°/h) war der Gußkörper supraleitend, wie aus der Widerstandskurve gemäß Fig. 5 hervorgeht, wonach bei 90 K der vollständige Widerstandsverlust eintritt.
Die Dimensionen des Gußkörpers waren:
- Außendurchmesser: : 100 mm
- Innendurchmesser: : 92 mm
- Höhe: : 110 mm

### Beispiel 2

Beispiel 1 wurde mit der Änderung wiederholt, daß die Schmelzetemperatur auf 1100°C gesteigert wurde. Das Ergebnis war dem des Beispiels 1 ähnlich, jedoch wies bei drei Gußversuchen ein Gußkörper einen Riß auf und war deswegen unbrauchbar.

### Beispiel 3

Die in Beispiel 1 verwendete Anlage wurde so abgeändert, daß die Rotationsachse des Kokillentopfes um etwa 15° gegen die Waagerechte geneigt war. Unter sonst vergleichbaren Bedingungen wie in Beispiel 1 wurde bei 500 Umdrehungen pro Minute ein zylinderförmiger Gußkörper erhalten, dessen Außendurchmesser beidseitig 100 mm betrug, dessen Dicke aber als Folge der Schwerkraft bodenseitig 5,5 mm und ringseitig nur 2,5 mm betrug.

### Beispiel 4

Beispiel 3 wurde mit der Änderung wiederholt, daß die Rotationsgeschwindigkeit 800 Umdrehungen pro Minute betrug. Hierdurch glich sich der Dickenunterschied zwischen den Enden des zylinderförmigen Gußkörpers fast aus, er betrug aber immer noch 1 mm.

### Beispiel 5

Die in Beispiel 3 verwendete Anlage wurde dadurch abgeändert, daß ein Kokillentopf mit leicht konischer Wandung verwendet wurde, dessen Durchmesser am Grund 19 mm und an der Oberkante 21 mm betrug. Dabei wurde ein leicht konischer Gußkörper erhalten, dessen Wandstärke oben und unten nahezu gleich war.

### Beispiel 6

Beispiel 1 wurde mit der Änderung wiederholt, daß nur 500 g Schmelze vergossen wurden. Es wurde ein zylinderförmiger Gußkörper mit einer Wandstärke von 2,5 mm erhalten, der sich ohne Probleme aus der Kokille entnehmen ließ.

### Beispiel 7

Es wurde eine Anlage gemäß der Fig. 2A verwendet, deren drehbare Kokille aus Edelstahl gemäß Werkstoff-Nr. 1.4571 nach DIN 17 440 200 mm Innendurchmesser und eine Höhe von 75 mm aufwies, wobei die Kokille durch den Motor im Bereich von 300 bis 1200 Upm gedreht werden konnte. Bei einer Schmelzemenge von 1500 g entstand ein rißfreier zylinderförmiger Gußkörper der Abmessungen 200 mm Durchmesser, 75 mm Höhe und 3,2 mm Dicke.

### Beispiel 8

Bei einer Anlage gemäß Fig. 2A wurde eine Kokille aus Kupfer mit einem Außendurchmesser von 40 mm und einer Länge von 100 mm sowie einem Abschlußring mit einer Öffnung von 20 mm verwendet und mit einer Drehzahl von 800 Upm gedreht. Aus 500 g Schmelze entstand ein Hohlzylinder mit einer Wandstärke von 10 mm. Dieser Gußkörper ließ sich jedoch nicht aus der Kokille entfernen.

### Beispiel 9

Beispiel 8 wurde mit der Änderung wiederholt, daß eine Kupferkokille der gleichen Abmessungen verwendet wurde, die aus drei Segmenten aufgebaut war, welche durch zwei äußere Spannringe zusammengehalten wurden (vergl. Fig. 3). Obwohl keine Dichtungselemente zwischen den Segmenten vorhanden waren, lief keine Schmelze aus der Kokille aus, da die schnelle Erstarrung der Schmelze an der kalten Kokillenwand eine sofortige Abdichtung der Kokille bewirkte. Die Segmente konnten nach Entfernen der Spannringe leicht vom Gußkörper abgehoben werden.

### Beispiel 10

Beispiel 7 wurde mit der Änderung wiederholt, daß eine Kokille mit Abschlußring gemäß Fig. 4 verwendet wurde. Nach Vergießen von 900 g Schmelze wurde ein zylinderförmiger Gußkörper erhalten, welcher an der oberen und unteren Kante Profile aufwies, die ein Stapeln mehrerer solcher Zylinder übereinander ermöglichen, ohne daß dazwischen Spalten freibleiben. Solche Zylindergruppen eignen sich besonders gut zum Aufbau von magnetischen Abschirmungen.

## Patentansprüche

1. Verfahren zur Herstellung rohrförmiger Formteile aus Hochtemperatur-Supraleiter-Material auf der Basis von Oxiden des Bismuts, Calciums, Strontiums und Kupfers, dadurch gekennzeichnet, daß man eine homogene Schmelze des Oxidgemisches in vorgegebener Stöchiometrie herstellt, daß man die Schmelze mit Temperaturen von 900 bis 1100°C in eine um ihre waagerechte Achse rotierende Gießzone einlaufen läßt, daß man das erstarrte Formteil aus der Gießzone entnimmt und daß man das Formteil 4 bis 150 Stunden bei 700 bis 900°C in sauerstoffenthaltender Atmosphäre tempert.

2. Verfahren nach Anspruch 1, dadurch gekennzeichnet, daß die Stöchiometrie gemäß der Formel Bi₂Sr₂CaCu₂Oₓ, wobei x für Werte zwischen 8 und 8,5 steht, vorgegeben ist.

3. Verfahren nach Anspruch 1, dadurch gekennzeichnet, daß die Stöchiometrie gemäß der Formel (Bi,Pb)₂Sr₂Ca₂Cu₃Oₓ, wobei x für Werte zwischen 10 und 13 steht, vorgegeben ist.

4. Verfahren nach mindestens einem der Ansprüche 1 bis 3, dadurch gekennzeichnet, daß man die Gießzone mit 300 bis 1200 Upm, vorzugsweise mit 400 bis 600 Upm, rotieren läßt.

5. Anlage zur Durchführung des Verfahrens nach mindestens einem der Ansprüche 1 bis 4, gekennzeichnet durch eine drehbar angeordneten Kokille (4,9), welche an ihrer mindestens einen offenen Stirnseite mit einem den freien Querschnitt verringernden Abschlußring (6) versehen ist, eine in das Innere der Kokille (4,9) hineinragende Gießrinne (7) und einen oberhalb der Gießrinne (7) angeordneten Tiegel (8), durch welchen die Gießrinne (7) mit Schmelze beaufschlagbar ist.

6. Anlage nach Anspruch 5, dadurch gekennzeichnet, daß die Kokille (4,9) regelbar antreibbar ist.

7. Anlage nach Anspruch 5 oder 6, dadurch gekennzeichnet, daß die Kokille (4) mit einer parallel zum Hüttenflur angeordneten, gegebenenfalls in einem Achsenlager (1) geführten Welle (2) kraftschlüssig verbunden ist, wobei die Welle (2) ihrerseits mit einem regelbaren Elektromotor (5) verbunden ist.

8. Anlage nach Anspruch 5 oder 6, dadurch gekennzeichnet, daß die Kokille (9) auf mindestens zwei mit Rollen (10) versehenen Achsen (11) drehbar gelagert ist und mit einer Gegendruckrolle (12) in ihrer Position gehalten wird.

9. Anlage nach mindestens einem der Ansprüche 5 bis 8, dadurch gekennzeichnet, daß die Kokille (4) an ihrer einen Stirnseite geschlossen ist und an ihrer offenen Stirnseite mit einem ihren freien Querschnitt verringernden Abschlußring (6) versehen ist.

10. Anlage nach mindestens einem der Ansprüche 5 bis 9, dadurch gekennzeichnet, daß die Kokille (4, 9) aus mehreren, in ihrer Längsachse verlaufenden Segmenten (13) aufgebaut ist, welche durch mehrere, ihren Umfang umgreifende Spannringe (15) zusammengehalten werden.

11. Anlage nach mindestens einem der Ansprüche 5 bis 10, dadurch gekennzeichnet, daß die Kokille (4, 9) an der Innenwand ihres einen Endes eine Stufe aufweist, während an ihrem entgegengesetzten Ende in die Innenseite des Abschlußringes (6) eine Ringnut (17) eingearbeitet ist.

12. Anlage nach Anspruch 11, dadurch gekennzeichnet, daß die Stufe durch Einlegen eines Ringes (16) gebildet wird.

13. Anlage nach mindestens einem der Ansprüche 5 bis 12, dadurch gekennzeichnet, daß die Kokille (4, 9) mindestens im Bereich ihrer Innenwandung aus metallischem Material besteht.

14. Anlage nach Anspruch 13, dadurch gekennzeichnet, daß das Material nichtrostender Stahl nach DIN 17 440, insbesondere Werkstoff-Nr. 1.4571, ist.

15. Anlage nach Anspruch 13, dadurch gekennzeichnet, daß das Material Buntmetall, insbesondere Nickel und/oder Kupfer, ist.

## Claims

1. Process for producing tubular molded parts made of high-temperature superconductor material based on oxides of bismuth, calcium, strontium and copper characterized in that a homogeneous melt of the oxide mixture with a specified stoichiometry is produced, in that the melt is allowed to run at temperatures of 900 to 1100°C into a casting zone rotating about its horizontal axis, in that the solidified molded part is removed from the casting zone, and in that the molded part is annealed for 4 to 150 hours at 700 to 900°C in an oxygen-containing atmosphere.

2. Process according to claim 1, characterized in that the stoichiometry is specified in accordance with the formula Bi₂Sr₂CaCu₂Oₓ, where x stands for values between 8 and 8.5.

3. Process according to claim 1, characterized in that the stoichiometry is specified in accordance with the formula (Bi, Pb)₂Sr₂Ca₂Cu₃Oₓ, where x stands for values between 10 and 13.

4. Process according to at least one of claims 1 to 3, characterized in that the casting zone is allowed to rotate at 300 to 1200 rev/min, preferably at 400 to 600 rev/min.

5. Plant for carrying out the process according to at least one of claims 1 to 4, characterized by a rotatably arranged mold (4, 9) which is provided at its at least one open end face with a front plate (6) which reduces the free cross section, a runner (7) extending into the interior of the mold (4, 9) and a crucible (8) which is arranged above the runner (7) and which is capable of feeding the runner (7) with melt.

6. Plant according to claim 5, characterized in that the mold (4, 9) can be controllably driven.

7. Plant according to claim 5 or 6, characterized in that the mold (4) is linked non-positively to a shaft (2) running parallel to the casting floor, optionally in a shaft bearing (1), the shaft (2) being in its turn linked to a controllable electric motor (5).

8. Plant according to claim 5 or 6, characterized in that the mold (9) is rotatably mounted on at least two shafts (11) provided with rollers (10) and is held in its position by a counterpressure roller (12).

9. Plant according to at least one of claims 5 to 8, characterized in that the mold (4) is closed at one of its end faces and is provided at its open end face with an front plate (6) which reduces its free cross section.

10. Plant according to at least one of claims 5 to 9, characterized in that the mold (4, 9) is made up of a plurality of segments (13) which extend in its longitudinal axis and which are held together by a plurality of clamping rings (15) engaging around its circumference.

11. Plant according to at least one of claims 5 to 10, characterized in that the mold (4, 9) has a step at the internal wall of one of its ends, while an annular groove (17) is incorporated in the inside of the front plate (6) at its opposite end.

12. Plant according to claim 11, characterized in that the step is formed by inserting a ring (16).

13. Plant according to at least one of claims 5 to 12, characterized in that the mold (4, 9) is composed of metallic material at least in the region of its internal wall.

14. Plant according to claim 13, characterized in that the material is stainless steel according to DIN 17 440, in particular material No. 1.4571.

15. Plant according to claim 13, characterized in that the material is nonferrous metal, in particular nickel and/or copper.

## Revendications

1. Procédé de production de pièces préformées tubulaires en matériau supraconducteur haute température à base d'oxydes de bismuth, de calcium, de strontium et de cuivre, caractérisé en ce qu'on produit une masse fondue homogène du mélange d'oxydes selon une stoechiométrie prédéterminée, qu'on laisse s'écouler la masse fondue à des températures comprises entre 900 et 1 100°C dans une zone de coulée tournant autour de son axe horizontal, qu'on prélève la pièce préformée solidifiée dans la zone de coulée et qu'on trempe la pièce préformée entre 4 et 150 h entre 700 et 900°C dans une atmosphère oxygénée.

2. Procédé selon la revendication 1, caractérisé en ce que la stoechiométrie est prédéterminée selon la formule Bi₂Sr₂CaCu₂Oₓ, x représentant des valeurs comprises entre 8 et 8,5.

3. Procédé selon la revendication 1, caractérisé en ce que la stoechiométrie est prédéterminée selon la formule (Bi,Pb)₂Sr₂Ca₂Cu₃Oₓ, x représentant des valeurs comprises entre 10 et 13.

4. Procédé selon au moins une des revendications 1 à 3, caractérisé en ce qu'on fait tourner la zone de coulée entre 300 et 1200 tr/min, de préférence entre 400 et 600 tr/min.

5. Installation de mise en oeuvre du procédé selon au moins une des revendications 1 à 4, caractérisée par une coquille (4, 9) disposée de façon à pouvoir tourner et dotée sur au moins une de ses faces frontales, ouverte, d'un anneau obturateur (6) réduisant la section transversale libre, par un bec de coulée (7) faisant saillie à l'intérieur de la coquille (4, 9) et par un creuset (8) disposé au-dessus du bec de coulée (7) et permettant d'alimenter le bec de coulée (7) en masse fondue.

6. Installation selon la revendication 5, caractérisée en ce que la coquille (4, 9) peut être entraînée de façon réglable.

7. Installation selon la revendication 5 ou 6, caractérisée en ce que la coquille (4) est raccordé mécaniquement à un arbre (2) disposé parallèlement au sol, introduit le cas échéant dans un palier (1), l'arbre (2) étant raccordé à son tour à un moteur électrique (5) réglable.

8. Installation selon la revendication S ou 6, caractérisée en ce que la coquille (9) repose de façon à pouvoir tourner sur au moins deux axes (11) munis de rouleaux (10) et est maintenue en position au moyen d'un rouleau de contre-pression (12).

9. Installation selon au moins une des revendications 5 à 8, caractérisée en ce que la coquille (4) est fermée sur une de ses faces frontales et est dotée sur sa face frontale ouverte d'un anneau obturateur (6) en diminuant la section transversale.

10. Installation selon au moins une des revendications 5 à 9, caractérisée en ce que la coquille (4, 9) est constituée de plusieurs segments (13) parallèles à son axe longitudinal et qui sont réunis par plusieurs anneaux de serrage (15) les enserrant sur leur périphérie.

11. Installation selon au moins une des revendications 5 à 10, caractérisée en ce que la coquille (4, 9) présente un gradin sur la paroi interne d'une de ses extrémités, alors qu'à son extrémité opposée une rainure annulaire (17) est ménagée dans la face interne de l'anneau obturateur (6).

12. Installation selon la revendication 11, caractérisée en ce que le gradin est formé par insertion d'un anneau (16).

13. Installation selon au moins une des revendications 5 à 12, caractérisée en ce que la coquille (4, 9) est en un matériau métallique, au moins dans la région de sa paroi interne.

14. Installation selon la revendication 13, caractérisée en ce que le matériau est de l'acier inoxydable selon la norme DIN 17 440, notamment le matériau n° 1. 4571.

15. Installation selon la revendication 13, caractérisée en ce que le matériau est un métal lourd non ferreux, notamment du nickel et/ou du cuivre.
